# EUROPÄISCHE PATENTANMELDUNG

(11) **EP 1 770 565 A1**
(43) Veröffentlichungstag der Anmeldung: **04.04.2007**
(21) Anmeldenummer: 05109042.1
(22) Anmeldetag: 29.09.2005
(51) Int. Cl.: G06F 17/50

(54) **Automatische Integration von FPGA-Beschaltungen auf einer Baugruppe**

(71) Anmelder: Knipping, Uwe, D-85598 Baldham (DE)
(72) Erfinder: Knipping, Uwe, D-85598 Baldham (DE)
(74) Vertreter: Schneider, Günther Martin

(57) **Zusammenfassung**

Verfahren zum Entwurf einer elektronischen Schaltung auf einer Baugruppe mit zumindest einem feldprogrammierbaren Bauelement, FPGA, das zur Realisierung zumindest eines Teiles der elektronischen Schaltung bestimmt ist, wobei die elektronische Schaltung einen Logikteil und einen Erweiterungsteil umfasst, wobei der Logikteil in zumindest einem FPGA implementiert wird und der Erweiterungsteil unabhängig vom Logikteil ist, dadurch gekennzeichnet, dass zumindest ein Teil des Erweiterungsteils aus Daten einer Datenbank entnommen wird.

## Beschreibung

Die Erfindung bezieht sich auf ein Verfahren zum Entwurf einer elektronischen Schaltung auf einer Baugruppe mit zumindest einem feldprogrammierbaren Bauelement, das zur Realisierung zumindest eines Teiles der elektronischen Schaltung bestimmt ist, sowie auf ein Verfahren zum Aufbau einer Datenbank zur Verwendung mit einem derartigen Entwurfsverfahren.

Heutige digitale elektronische Schaltungen werden immer höher in einem Baustein integriert. Diese höhere Integration erlaubt es, immer komplexere und größere Schaltungen in Gehäusen mit einem ungefähr gleich bleibenden Formfaktor einzubauen. Die Herstellung dieser Bausteine wird immer teurer und zeitaufwendiger. Die Entwicklung muss jedoch immer schneller abgeschlossen sein, und es darf hierbei kein Fehler auftreten, da eine erneute Herstellung zu teuer und zu zeitaufwendig ist. Aus diesem Grund wird die Funktion diese Bausteine zuerst auf einer Baugruppe mit programmierbaren Bausteinen verifiziert. Diese Baugruppe hat die gleiche Funktion wie der spätere Baustein, ist aber schneller und preisgünstiger in der Herstellung als die ersten Exemplare des Bausteines. Des Weiteren werden programmierbare Bausteine auch für Kleinserien verwendet, wenn z.B. die Herstellung von ASICs zu teuer ist.

Die programmierbaren Bausteine, feldprogrammierbare Bausteinen (field programmable gate array, abgekürzt FPGA) genannt, benötigen eine zusätzliche, bausteinspezifische Beschaltung, die später integriert werden muss. Dies ist ein für die einzelnen Bausteine individueller Prozess.

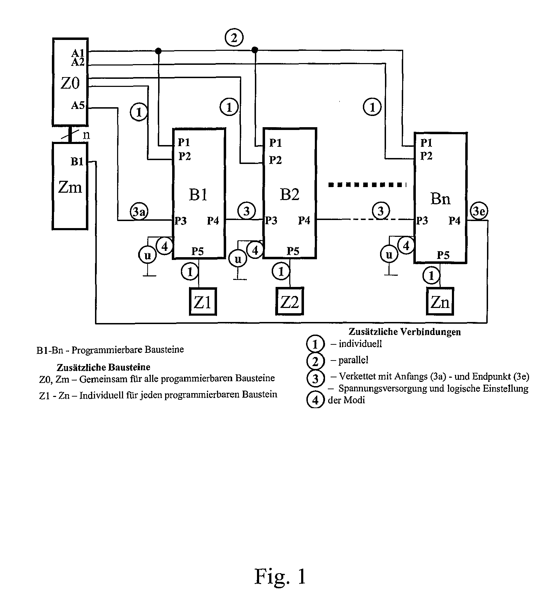

FPGAs benötigen neben der implementierten Logik noch erweiterte Verbindungen zu ihrer vollständigen Funktion. Diese sind in der Regel nicht in der Schaltungsbeschreibung der zu implementierenden Logik enthalten, sondern sie ergeben sich aus den Rahmenbedingungen der Implementierung. Beispiele hierfür sind die Spannungsversorgung und die Anschlüsse zum Programmieren sowie Referenzwiderstände. Fig. 1 zeigt die zusätzlichen Erweiterungen. B1 - Bn sind hierbei die programmierbaren Bausteine, Z0 - Zn zusätzliche Bausteine. Z0 und Zm können z.B. Stecker sein, Z1 - Zn Widerstände oder Kondensatoren. Z0 und Zm könnten auch Teile einer komplexen Ladelogik bestehend aus Flash-Speicher, Controller und einer Mikroprozessor-Schnittstelle (MPU) sein. U bezeichnet die Spannungsversorgung sowie Verbindungen einiger Pins zur Einstellung bestimmter interner Operationsmodi. Bei FPGAs der Firma XILINX können dies die Pins M0-M2 sein, mit denen das Ladeprotokoll bestimmt wird. Alle eingezeichneten Verbindungen sind notwendige, zusätzliche Verbindungen.

Gemäß dem im Stand der Technik benannten Entwurfsmethoden müssen die Erweiterungen individuell für jeden Baustein vorgenommen werden. Dies ist eine zeitaufwendige und fehleranfällige Methode.

Aufgabe dieser Erfindung ist es, Verfahren bereitzustellen, mit welchen diese Schaltungsteile aufgrund individueller Randbedingungen und Erfordernissen des Entwicklers auf der gesamten Baugruppe automatisch eingefügt werden können.

Diese Aufgabe wird durch die Verfahren gemäß den Ansprüchen gelöst.

Erfindungsgemäß bereitgestellt wird also ein Verfahren zum Entwurf einer elektronischen Schaltung auf einer Baugruppe mit zumindest einem feldprogrammierbaren Bauelement, FPGA, das zur Realisierung zumindest eines Teiles der elektronischen Schaltung bestimmt ist, wobei die elektronische Schaltung einen Logikteil und einen Erweiterungsteil umfasst, wobei der Logikteil in zumindest einem FPGA implementiert wird und der Erweiterungsteil unabhängig vom Logikteil ist, dadurch gekennzeichnet, dass zumindest ein Teil des Erweiterungsteils aus Daten einer Datenbank entnommen wird.

Gemäß einem weiteren Aspekt der Erfindung bereitgestellt wird ein Verfahren zum Aufbau einer Datenbank zur Verwendung für den Entwurf einer elektronischen Schaltung auf einer Baugruppe mit zumindest einem feldprogrammierbaren Bauelement, FPGA, das zur Realisierung zumindest eines Teiles der elektronischen Schaltung bestimmt ist, wobei die elektronische Schaltung einen Logikteil und einen Erweiterungsteil umfasst, wobei der Logikteil in zumindest einem FPGA implementiert wird und der Erweiterungsteil unabhängig vom Logikteil ist, dadurch gekennzeichnet, dass die Datenbank Daten enthält, welche sich auf zumindest einen Teil des Erweiterungsteils beziehen.

Vorteilhafte Weiterbildungen der Erfindung können die folgenden Merkmale umfassen:

Die Daten der Datenbank können in zwei Gruppen unterteilt sein, wobei die erste Gruppe diejenigen Erweiterungen enthält, die sich auf Bauelemente beziehen, und die zweite Gruppe diejenigen Erweiterungen enthält, die sich auf Verbindungen zwischen Bauelementen beziehen.

Hierbei kann die erste Gruppe in bauteilindividuelle Erweiterungen und bauteil-gemeinsame Erweiterungen unterteilt sein.

Die zweite Gruppe kann in Verbindungs-individuelle Erweiterungen, in Parallel-Verbindungs-Erweiterungen und in Verkettungs-Verbindungs-Erweiterungen unterteilt sein.

Der Erweiterungsteil kann zusätzlich Daten bezüglich Energieversorgung und/oder Mittel zur Einstellung von Modi des zumindest einen FPGA aufweisen.

Der Erweiterungsteil kann jeweils generische Schaltungsbeschreibungen sowie hierzu zugeordnete Implementierungsvorschriften enthalten.

Die Baugruppe kann einen Schaltungsträger, insbesondere eine Leiterplatte, umfassen.

Der in dem zumindest einen FPGA realisierte Teil der elektronischen Schaltung kann zur späteren Realisierung in zumindest einem anwendungsspezifischen integrierten Schaltkreis bestimmt sein.

Die Erfindung umfasst auch eine Datenbank, die aufgebaut ist mit dem erfinderischen Verfahren zum Aufbau einer Datenbank.

Ein Vorteil der Erfindung ist, dass die Eingabe dieser Erweiterungen auf Baugruppenebene basierend auf den Erfordernissen durchgeführt werden kann, ohne dass der Benutzer sich um die technische Realisierung kümmern muss.

Die Erfindung wird anhand der Zeichnung näher beschrieben. In der Zeichnung zeigen:
Fig. 1 eine Baugruppe mit zusätzlichen Verbindungen zu den FPGAs und
Fig. 2 den Aufbau der Datenbank gemäß der Erfindung.

Programmierbare Bausteine ermöglichen viele verschiedene Operationsmodi, die sich durch eine externe Beschaltung einstellen lassen. Erfindungsgemäß werden diese Erweiterungen unabhängig von den Erfordernissen in zwei Gruppen eingeteilt, nämlich in die Gruppe der Erweiterungen mit Bauteilen und die Gruppe der Erweiterungen mit zusätzlichen Verbindungen. Jede dieser Gruppen enthält weitere Unterteilungen, die im Folgenden aufgeführt sind.

Erste Gruppe: Bauteileerweiterung.
a) Individuelle Erweiterungen. In Fig. 1 ist dies mit Z1 - Zn dargestellt. Hierbei wird für jede zu erweiternde Komponente auf der Baugruppe ein oder mehrere zusätzliche Komponenten hinzugefügt. Die Verbindung der neuen Komponenten zur existierenden erfolgt nach einem vorgegebenen Schema, welches in einer Datenbank gespeichert ist. Hierbei wird ebenfalls gespeichert, dass der Anschluss P5 mit einen entsprechenden von Z1... verbunden werden muss.
   Ein Beispiel hierfür ist der Anschluss eines Referenzwiderstandes für die Eingangs-/Ausgangstechnologie DCI (Digital Controlled Impedance).
b) Gemeinsame Bausteine für die gesamte Baugruppe. Hierbei werden ein oder mehrere Komponenten auf die Baugruppe hinzugefügt, die anschließend mit allen zu erweiternden Komponenten nach dem in Punkt 2 aufgeführten Muster verbunden werden; In Fig. 1 ist dies durch die zusätzliche Komponente Z0 und Zm dargestellt. Ein Beispiel hierfür ist ein Stecker für eine externe Ladelogik der FPGAs. Hierbei werden die feststehenden Verbindungen zwischen Z0 und Zm in Form einer Schaltungsbeschreibung gespeichert, die notwendigen Verbindungen zu den frei programmierbaren Bausteinen entsprechend der Beschaltung. Dies ist im nächsten Absatz erläutert.

Zweite Gruppe: Verbindungen
a) Individuelle Verbindung zweier Pins. Hierbei erfolgt die Verbindung individuell zwischen zwei Pins auf der Baugruppe. Diese können sowohl von den existierenden Bausteinen als auch von den neu eingefügten Bausteinen sein (vgl. Fig.1 (1)). In der Datenbank wird gespeichert, dass Anschluss A2 und alle weiteren (in der Figur nicht mit Namen gekennzeichnet) individuellen Anschlüsse von Z0 an den Anschluss P1 der frei programmierbaren Bausteine verlaufen.
b) Parallele Verbindung gleicher Pins zu allen gleichartigen Pins individueller existierender Komponenten auf dem Board. Eine parallele Verbindung liegt vor, wenn alle zu erweiternden Bausteine auf der Baugruppe parallel mit einem Netz verbunden werden. Eine Verbindung zu den zusätzlich auf die Baugruppe implementierten Bausteinen ist ebenfalls möglich. Im obigen Beispiel (Fig. 1 (2))würde in der Datenbank gespeichert sein, dass der Anschluss A1 von Z0 mit allen programmierbaren Bausteinen, jeweils an den Anschluss P1 verbunden wird.
c) Verkettete Verbindung. Verkettete Verbindungen liegen vor, wenn der Ausgang eines zu erweiternden Bausteines mit dem Eingang eines anderen verbunden wird. Ein Beispiel hierfür ist die DOUT - DIN-Verbindung eines JTAG-Anschlusses. Hierbei ist der Start- und der Endpunkt individuell zu berücksichtigen (Fig. 1, (3) mit Anfangs- (3a) und Endverbindung (3e)). In der Datenbank muss jeweils der Ausgang (im Beispiel P4) und der Eingang (P3) sowie der Anfangs- (Anschluss A5 an Z0) und der Endpunkt (B 1 an Zm) gespeichert sein.

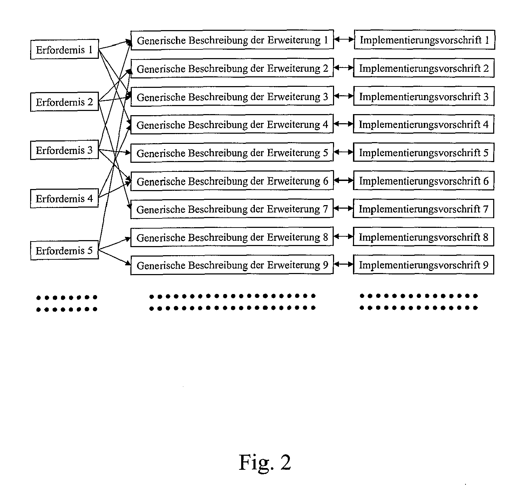

Die Realisierung der Erfindung erfolgt mit Hilfe einer Software und einer damit verbundenen Datenbank. Hierin werden die Erfordernisse zusammen mit den notwendigen Schaltungserweiterungen abgelegt. Dies kann aussehen, wie in Fig. 2 gezeigt ist.

Demnach ist der generelle Aufbau der Datenbank wie folgt: Erfordernisse können z.B. die Implementierung der Ladelogik wie JTAG, Seriell oder Parallel sein. Eine "Generische Beschreibung der Erweiterung" sind z.B. die Verbindungen nach Punkt 2. Die Implementierungsvorschrift beinhaltet u.a. die Anschlusspins für die Bausteine.

Die Erweiterungen werden entsprechend der obigen Einteilung nach Bauteilen und Verbindungen gespeichert. Dies kann wie folgt aussehen: Notwendige Komponenten für diese Erweiterung. Dies kann sowohl individuell als auch gemeinsam sein. Die Verbindungen zwischen neuen Komponenten (Z0 und Zm) werden in Form einer Schaltungsbeschreibung in der Datenbank gespeichert.

Anschlusspunkte für die zu erweiternden Komponenten. Hierbei wird festgelegt, welcher Anschluss von den neu eingefügten Komponenten an welchen Anschluss der programmierbaren Bausteine geht und in welcher Form die Verbindung realisiert werden soll. Dies kann sowohl individuell, parallel oder verkettet sein.

Start- und Endpunkt von parallelen und verketteten Verbindungen. Wenn die existierenden Komponenten auf der Baugruppe und die gewünschten Erweiterungen bekannt sind, erfolgt die Implementierung durch eine Software, die auf den obigen Datensatz zugreift und die dort allgemein formulierten Bedingungen auf die individuelle Baugruppe umsetzt.

Mit der Software und der angeschlossenen Datenbank kann der Benutzer seine Erfordernisse eingeben, die Implementierung erfolgt automatisch. Dies führt zu einem beträchtlichen Zeitgewinn beim Entwurf. Darüber hinaus werden Fehler in der Implementierung vermieden.

## Patentansprüche

1. Verfahren zum Entwurf einer elektronischen Schaltung auf einer Baugruppe (L) mit zumindest einem feldprogrammierbaren Bauelement, FPGA, (B1, B2, ..., Bn), das zur Realisierung zumindest eines Teiles der elektronischen Schaltung bestimmt ist,
wobei die elektronische Schaltung einen Logikteil und einen Erweiterungsteil umfasst, wobei der Logikteil in zumindest einem FPGA implementiert wird und der Erweiterungsteil unabhängig vom Logikteil ist,
**dadurch gekennzeichnet, dass**
zumindest ein Teil des Erweiterungsteils (E1, ..., En) aus Daten einer Datenbank entnommen wird.

2. Verfahren zum Aufbau einer Datenbank zur Verwendung für den Entwurf einer elektronischen Schaltung auf einer Baugruppe (L) mit zumindest einem feldprogrammierbaren Bauelement, FPGA, (B1, B2, ..., Bn), das zur Realisierung zumindest eines Teiles der elektronischen Schaltung bestimmt ist,
wobei die elektronische Schaltung einen Logikteil und einen Erweiterungsteil umfasst, wobei der Logikteil in zumindest einem FPGA implementiert wird und der Erweiterungsteil unabhängig vom Logikteil ist,
**dadurch gekennzeichnet, dass**
die Datenbank Daten enthält, welche sich auf zumindest einen Teil des Erweiterungsteils (E1, ..., En) beziehen.

3. Verfahren gemäß Anspruch 1 oder 2, wobei die Daten der Datenbank in zwei Gruppen unterteilt sind, wobei die erste Gruppe diejenigen Erweiterungen (Z0, ..., Zm, ..., Zn) enthält, die sich auf Bauelemente beziehen, und die zweite Gruppe diejenigen Erweiterungen enthält, die sich auf Verbindungen (1, 2, 3, 4) zwischen Bauelementen beziehen.

4. Verfahren gemäß Anspruch 3, wobei die erste Gruppe in bauteilindividuelle Erweiterungen (Z1, ..., Zn) und bauteil-gemeinsame Erweiterungen (Z0, ..., Zm) unterteilt ist.

5. Verfahren gemäß Anspruch 3 oder 4, wobei die zweite Gruppe in Verbindungs-individuelle Erweiterungen (1), in Parallel-Verbindungs-Erweiterungen (2) und in Verkettungs-Verbindungs-Erweiterungen (3) unterteilt ist.

6. Verfahren gemäß einem der vorherigen Ansprüche, wobei der Erweiterungsteil zusätzlich Daten (3, 4) bezüglich Energieversorgung und/oder Mittel zur Einstellung von Modi des zumindest einen FPGA aufweist.

7. Verfahren gemäß einem der vorherigen Ansprüche, wobei der Erweiterungsteil jeweils generische Schaltungsbeschreibungen sowie hierzu zugeordnete Implementierungsvorschriften enthält.

8. Verfahren gemäß einem der vorherigen Ansprüche, wobei die Baugruppe (L) einen Schaltungsträger, insbesondere eine Leiterplatte, umfasst.

9. Verfahren gemäß einem der vorherigen Ansprüche, wobei der in dem zumindest einen FPGA (B1, B2, B3) realisierte Teil der elektronischen Schaltung zur späteren Realisierung in zumindest einem anwendungsspezifischen integrierten Schaltkreis bestimmt ist.

10. Datenbank mit Daten gemäß einem der Ansprüche 2 bis 8.
